**Europäisches Patentamt**

**European Patent Office**

**Office européen des brevets**

(19)

(11)     **EP 1 128 211 A1**

(12)                    **EUROPEAN PATENT APPLICATION**

(43) Date of publication:
    **29.08.2001 Bulletin 2001/35**

(51) Int Cl.$^7$: **G03F 1/14**

(21) Application number: **00103591.4**

(22) Date of filing: **21.02.2000**

(84) Designated Contracting States:
    **AT BE CH CY DE DK ES FI FR GB GR IE IT LI LU
    MC NL PT SE**
    Designated Extension States:
    **AL LT LV MK RO SI**

(71) Applicant: **MOTOROLA, INC.**
    **Schaumburg, IL 60196 (US)**

(72) Inventors:
    • **Mancini, David P.**
      **Fountain Hills, Arizona 85268 (US)**

    • **Resnick, Douglas J.**
      **Phoenix, Arizona (US)**

(74) Representative: **Hudson, Peter David et al
    Motorola,
    European Intellectual Property Operations,
    Midpoint
    Alencon Link
    Basingstoke, Hampshire RG21 7PL (GB)**

(54)    **Lithographic printing method using a low surface energy layer**

(57)    A method of contact printing on a device using a partially transparent mask (18) having first and second surfaces, comprises the steps of applying a layer of low surface energy polymeric material (22) to the first surface of the mask; placing the first surface (24) of the mask contiguous to the device (10), the layer of low surface energy polymeric material being substantially in contact with the device; and applying radiation (32) to the second surface of the mask for affecting a pattern in the device.

**FIG. 5**

EP 1 128 211 A1

## Description

Background of the Invention

The present invention relates in general to contact printing and, more particularly, to a method of coating a mask in a photolithographic process.

The fabrication of integrated circuits involves the creation of several layers of materials that interact in some fashion. One or more of these layers may be patterned so various regions of the layer have different electrical characteristics, which may be interconnected within the layer or to other layers to create electrical components and circuits. These regions may be created by selectively introducing or removing various materials. The patterns that define such regions may be created by lithographic processes. For example, a layer of photoresist material is applied onto a layer overlying a wafer substrate. A mask (containing clear and opaque areas) is used to selectively expose this photoresist material by a form of radiation, such as ultraviolet light, electrons, or x-rays. Either the photoresist material exposed to the light, or that not exposed to the light, is removed by the application of a solvent. An etch may then be applied to the layer not protected by the remaining resist, and when the resist is removed, the layer overlying the substrate is patterned.

In this photolithographic process, the mask may be placed in contact with the photoresist (contact printing), may be placed close to the photoresist (proximity printing), or may be projected over a larger distance (projection printing). The contact printing method was probably the earliest method used to produce patterns on integrated circuits and may provide excellent resolution and high throughput. The mask must be correctly aligned on the photoresist/layer, e.g., when previous patterns have been created. The mask is secured to the photoresist covered layer by clamping or vacuum, for example.

However, for contact printing, defects in the pattern or the mask are routinely experienced, especially when the mask is used repeatedly to print several substrates consecutively without cleaning the mask. These defects print on the next layer that is exposed to the mask. Consequently, hard surface masks used in contact printing must be inspected and cleaned regularly, a time consuming and expensive process. And if the defects cannot be eliminated, the masks must be replaced.

These defects in contact printing occur when particles of the photoresist, being tacky or sticky in nature, stick to the mask. Conventional masks comprise a chrome and glass surface, with the radiation passing through the glass but not the chrome. Glass and chrome both have a high surface energy and readily induce particles of photoresist and dirt to cling thereto. When particles stick to the glass, the radiation is absorbed (blocked) and does not reach the photoresist on subsequent layers being processed. Failure of the radiation to reach these small areas on subsequent layers of photoresist creates defects. Furthermore, particles sticking to either the glass or the chrome prevent close contact (creating a gap) between the mask and the photoresist surface, reducing resolution of the resulting image. As resolution is reduced, the lines of demarcation between areas become less defined. Therefore, it is desired to have minimal diffraction induced resolution loss.

Efforts in the past to resolve these problems include applying a thin, one molecule deep, conversion coating (fluorinated hydrocarbon chlorosilane monomers) to the mask. This coating would bond to the glass portion of the mask, but has less affinity to bond with the chrome portion of the mask. Test results using a small number of samples showed that this coating had very limited durability. As a result of this lack of durability, the coating would have to be reapplied after only a few uses.

Therefore, an improved method of contact printing is desired that greatly reduces defects by reducing the number of particles attaching to the mask during the photolithography process.

Brief Description of the Drawings

FIG. 1 illustrates a front view of layers of an integrated circuit prior to processing with a photolithographic mask;
FIG. 2 illustrates a front view of a mask;
FIG. 3 illustrates a front view of a mask being subjected to heat;
FIG. 4 illustrates a cut away view taken along the line 4-4 of FIG. 1 during processing with the mask in contact with the integrated circuit;
FIG. 5 illustrates a cut away view taken along the line 4-4 of FIG. 1 during processing with the mask separated from the integrated circuit;
FIGs. 6-11 illustrate semiconductor processing of the integrated circuit of FIG. 1 after processing with the mask.

Detailed Description of the Preferred Embodiment

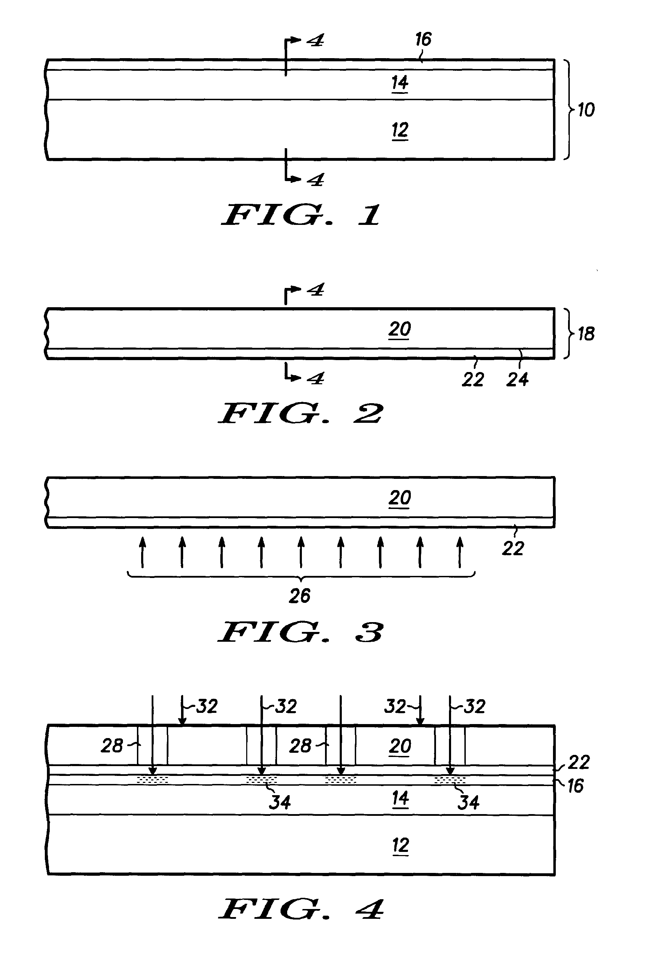

Referring to FIG. 1, an integrated circuit 10 under manufacture is shown including a substrate 12 underneath a layer 14. The substrate 12 and layer 14 may comprise any material used in making integrated circuits, e.g., silicon or gallium arsenide as currently known. By conventional methods, a layer 16 of photoresist is applied to layer 14.

Referring to FIG. 2, a simple figure of a mask 18 is shown comprising a base 20 typically manufactured of glass or quartz, with sections of opaque material, typically chrome, interspersed throughout in a manner well known to those skilled in the art. A layer 22 of low surface energy polymeric material containing solvents is applied to the surface 24 of the base 20. The material, in one embodiment, comprises a tetrafluoroethylene containing resin, or a copoylmer of tetrafluoroethylene and bistrifluoromethyl difluoro dioxole. These materials are temperature resistant, durable, transparent, and have substantially a zero moisture absorption and a low coefficient of friction. More importantly, they are resistant to adhesion which prevents the material from collecting particles of resist and dirt when making contact with the resist. In other embodiments, the material may comprise a amorphous fluoropolymer, hydrocarbon or a silicone based material, for example. The material may be applied in any one of several conventional ways, such as spin coating, spraying, dipping, or vapor deposition. The material may be applied with a thickness, for example, of 40Å to 50 microns, but 700Å has been shown to work very well.

In FIG. 3, heat 26 (represented by the arrows) is applied to the layer 22 of low surface energy polymeric material to remove the solvents. Even though the material is thermally stable with a high $T_g$, heating (baking) the material above $T_g$ (approximately 160° C to 300° C) for a short duration, e.g. baking for 3 minutes at 180° C, will remove solvents within the material.

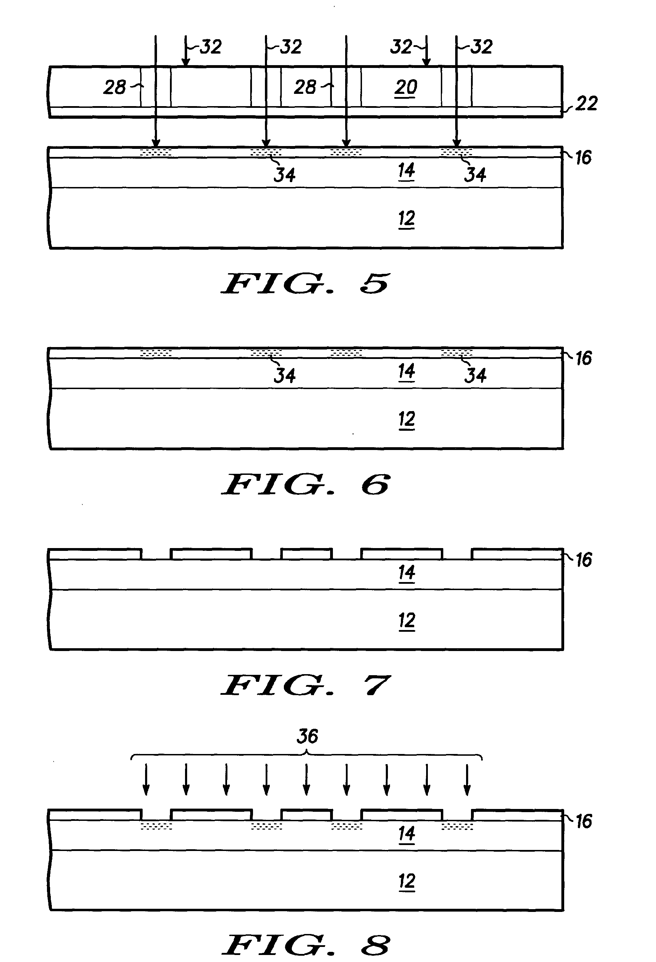

Referring to FIG. 4, a cutaway view is shown of the mask 18 in contact with the integrated circuit 10. As mentioned above, transparent material 28 is interspersed within the base 20. Radiation 32 (represented by the arrows) is applied to the surface 30 of the base 20, being absorbed and reflected by the base 20, but passing through transparent material 28 and low surface energy polymeric material of layer 22 to strike the resist of layer 16 creating a pattern.

Then the mask 18 is removed without substantially any of the resist of layer 16 sticking to the material on layer 22. Dry adhesion between the mask 18 and layer 16 and between layer 16 to the underlying layer 14, may be expressed by the dispersion interaction as follows:

$$W_{a(MR)} = 2(\gamma M^d \gamma R^d)$$

$$W_{a(RS)} = 2(\gamma R^d \gamma S^d)$$

where the suffixes M, R, and S denote the mask 18, layer 16, and layer 14, respectively. $W_a$ is the work of adhesion indicating the affinity between two materials denoted by suffixes, and $\gamma^d$ is the dispersion component of surface free energy. Since adhesion increases with $W_a$, the photoresist will stick to the photomask rather than the substrate when

$$W_{a(MR)} > W_{a(RS)}$$

Substituting the first and second formulas into the third produces

$$\gamma M^d > \gamma S^d$$

Consequently, to prevent the photoresist sticking to the mask, $\gamma M^d$ must be smaller than $\gamma S^d$. Lowering the surface energy of the mask by coating its surface with the appropriate low surface energy material accomplishes this goal. By the resist of layer 16 not sticking to the material 22, at least two advantages over the prior art are gained. First, the mask 18 (material 22) can be placed in direct contact (no gap) with the photoresist of layer 16 on subsequent masking operations thereby providing better resolution. Second, the radiation 32,36 passing through the glass 28 will not be "blocked" from reaching the subsequent resist by particles of resist from the previous operation, thereby preventing defects. One test of a low surface energy material demonstrated no change in exposure energy, no introduction of defects and no loss of resolution after 100 wafer exposures.

FIG. 5 illustrates another embodiment wherein the mask 18 is separated from the layer 16 of resist prior to the radiation 32,36 being applied. This method is typically referred to as proximity printing. The mask 18 is placed in contact with layer 16 for proper allignment.

FIGs. 6 and 7 illustrate typical processes after the mask 18 is removed. The portions 34 of the photoresist of layer 16 irradiated (exposed) are made soluble in a solvent (developer), the soluble portion of the photoresist of layer 16 being removed. It should be understood that, in another embodiment, the radiation may make the photoresist of layer 16 insoluble, depending on the solvent selected, with the non-radiated portion being removed (not shown here).

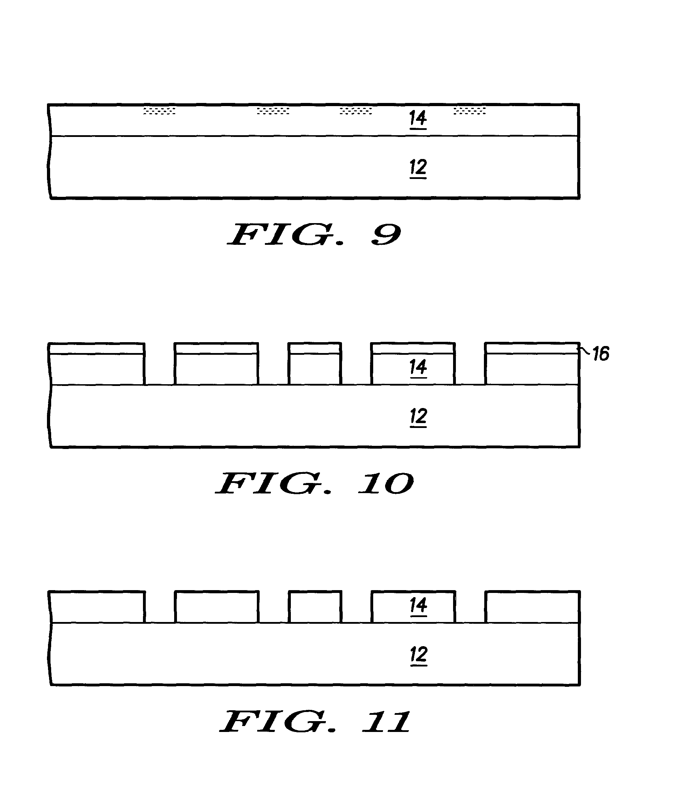

Then, using conventional methods, the integrated circuit 10 is further processed. For example, FIGs. 8 and 9 show radiation 36 such as ions being implanted into layer 14 prior to the layer 16 being removed. ' Alternatively, for example, FIGs. 10 and 11 show layer 14 being etched prior to the removal of the layer 16. This invention may be applied to contact printing or stamping lithography in many other technologies besides the semiconductor industry, e.g., the making of compact discs (CDs) or other such device. CDs are manufactured with a lithographic process by replicating data as a series of bumps on a plastic disc that can be read with the use of a laser beam. In a manner well known to those in the CD industry, a nickel pattern is formed by electroplating nickel onto a photoresist patterned glass master. A stamper is then formed by separating the nickel from the glass and removing the photoresist. The pattern information on the stamp is transferred into a soft and malleable injection molded polycarbonate via a stamping process. This process typically contaminates the stamp when excess polycarbonates and light dirt or soil adhere to the nickel master, causing similar problems as discussed above for the semiconductor example. A low surface energy release agent coating can be applied to the nickel master to prevent contamination.

Yet another embodiment comprises placing the mask 18 a predetermined distance from the device (as represented in FIG. 5) on which a pattern is to be created by projecting radiation typically through a lens. This method is typically referred to as projection printing. The layer 22 of low surface energy polymeric material prevents dirt from the environment from sticking to the mask 18.

In summary, a photolithography mask with a coating material of low surface energy polymeric material is provided that has a low surface energy, and is (1) easily applied, (2) easily removed (e.g., with a fluorinated solvent), (3) is transparent to exposure radiation, (4) is thin and uniformly applied to avoid resolution losses, and (5) is cohesively strong for durability.

## Claims

1. A method of contact printing on a device using a mask (18) that is partially transparent having first and second surfaces, is characterised by the steps of:

   (a) applying a layer of low surface energy polymeric material (22) to the first surface (24) of the mask;
   (b) placing the first surface (24) of the mask contiguous to the device, the layer of low surface energy polymeric material being substantially in contact with the device; and
   (c) applying radiation (32) to the second surface of the mask for affecting a pattern in the device.

2. The method of claim 1 wherein step (a) is characterised by the step of applying amorphous tetrafluoroethylene containing resin to the surface of the mask.

3. The method of claim 1 wherein step (a) is characterised by the step of applying amorphous fluoropolymer with a thickness of substantially 700Å to the surface of the mask.

4. The method of claim 1 wherein step (a) is characterised by the step of applying amorphous fluoropolymer with a thickness within the range of 40Å to 50 microns to the surface of the mask.

5. The method of claim 1 wherein step (a) is characterised by the step of applying a copoylmer of tetrafluoroethylene and bistrifluoromethyl difluoro dioxole to the surface of the mask.

6. The method of claim 1 wherein step (a) is characterised by the step of applying a hydrocarbon to the surface of the mask.

7. The method of claim 1 wherein step (a) is characterised by the step of applying a silicone based material to the surface of the mask.

8. The method of claim 1, subsequent to step (a), further characterised by the step of (d) heating (26) the low surface energy polymeric material.

9. The method of claim 1, subsequent to step (b), further characterised by the step of (e) separating the mask and the resist.

FIG. 1

FIG. 2

FIG. 3

FIG. 4

FIG. 5

FIG. 6

FIG. 7

FIG. 8

## FIG. 9

## FIG. 10

## FIG. 11

EP 1 128 211 A1

**European Patent Office**

**EUROPEAN SEARCH REPORT**

EP 00 10 3591

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | GB 2 249 196 A (NIPPON CMK KK) 29 April 1992 (1992-04-29) | 1-4,7,9 | G03F1/14 |
| Y | * the whole document * | 5 | |
| X | FR 2 280 924 A (SILEC SEMI CONDUCTEURS) 27 February 1976 (1976-02-27) * page 3, line 6 - line 21; claim 1 * | 1-4,9 | |
| X | PATENT ABSTRACTS OF JAPAN vol. 006, no. 121 (P-126), 6 July 1982 (1982-07-06) & JP 57 046243 A (NEC CORP), 16 March 1982 (1982-03-16) * abstract * | 1,2,4,8,9 | |
| X | PATENT ABSTRACTS OF JAPAN vol. 014, no. 146 (C-0704), 20 March 1990 (1990-03-20) & JP 02 015169 A (TDK CORP), 18 January 1990 (1990-01-18) * abstract * | 1,4,9 | |
| X | US 4 514 489 A (GARCIA CARLOS N ET AL) 30 April 1985 (1985-04-30) * the whole document * | 1,4,9 | **TECHNICAL FIELDS SEARCHED (Int.Cl.7)**<br>G03F |
| X | PATENT ABSTRACTS OF JAPAN vol. 006, no. 005 (P-097), 13 January 1982 (1982-01-13) & JP 56 130748 A (MATSUSHITA ELECTRIC IND CO LTD), 13 October 1981 (1981-10-13) * abstract * | 1-4,6,9 | |
| Y | US 5 356 739 A (KAWASAKI TORU ET AL) 18 October 1994 (1994-10-18) * the whole document * | 5 | |

-/--

The present search report has been drawn up for all claims

| Place of search | Date of completion of the search | Examiner |
|---|---|---|
| THE HAGUE | 18 July 2000 | Haenisch, U |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

8

**European Patent Office**

## EUROPEAN SEARCH REPORT

Application Number

EP 00 10 3591

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | PATENT ABSTRACTS OF JAPAN<br>vol. 007, no. 133 (M-221),<br>10 June 1983 (1983-06-10)<br>& JP 58 049221 A (FUJITSU KK),<br>23 March 1983 (1983-03-23)<br>* abstract * | | |
| | | | **TECHNICAL FIELDS SEARCHED** (Int.Cl.7) |

The present search report has been drawn up for all claims

| Place of search | Date of completion of the search | Examiner |
|---|---|---|
| THE HAGUE | 18 July 2000 | Haenisch, U |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 00 10 3591

This annex lists the patent family members relating to the patent documents cited in the above-mentioned European search report.
The members are as contained in the European Patent Office EDP file on
The European Patent Office is in no way liable for these particulars which are merely given for the purpose of information.

18-07-2000

| Patent document cited in search report | | Publication date | Patent family member(s) | | Publication date |
|---|---|---|---|---|---|
| GB 2249196 | A | 29-04-1992 | JP | 4125641 A | 27-04-1992 |
| FR 2280924 | A | 27-02-1976 | NONE | | |
| JP 57046243 | A | 16-03-1982 | NONE | | |
| JP 02015169 | A | 18-01-1990 | JP | 2681488 B | 26-11-1997 |
| US 4514489 | A | 30-04-1985 | NONE | | |
| JP 56130748 | A | 13-10-1981 | JP<br>JP | 1381635 C<br>61048707 B | 09-06-1987<br>25-10-1986 |
| US 5356739 | A | 18-10-1994 | JP<br>JP | 2952962 B<br>3067262 A | 27-09-1999<br>22-03-1991 |
| JP 58049221 | A | 23-03-1983 | NONE | | |

EPO FORM P0459

For more details about this annex : see Official Journal of the European Patent Office, No. 12/82